# EUROPEAN PATENT APPLICATION

(11) **EP 1 469 510 A2**
(43) Date of publication of application: **20.10.2004**
(21) Application number: 04009164.7
(22) Date of filing: 16.04.2004
(51) Int. Cl.: H01L 21/311, H01L 21/3213

(54) **Method for fabricating a gate structure of a field effect transistor**

(30) Priority: 17.04.2003 US 418995
(71) Applicant: Applied Materials, Inc., Santa Clara, California 95054 (US)
(72) Inventor: Kumar, Ajay, Sunnyvale, CA 94087 (US); Nallan, Padmapani, C., San Jose, CA 95148 (US)
(74) Representative: Zimmermann, Gerd Heinrich

(57) **Abstract**

A method for fabricating a gate structure of a field effect transistor is disclosed. The gate structure is fabricated by sequentially etching a material stack comprising a gate electrode layer formed on a gate dielectric layer. Prior to etching the gate dielectric layer, polymeric residues formed on the substrate when the gate electrode is etched are removed. The polymeric residue is removed by exposing the substrate to a plasma comprising one or more fluorocarbon containing gases and at least one inert gas.

## Description

### BACKGROUND OF THE INVENTION

The present invention generally relates to a method for fabricating devices on semiconductor substrates. More specifically, the present invention relates to a method of fabricating a field effect transistor.

Ultra-large-scale integrated (ULSI) circuits typically include more than one million transistors that are formed on a semiconductor substrate and which cooperate to perform various functions within an electronic device. Such transistors may include complementary metal-oxide-semiconductor (CMOS) field effect transistors.

A CMOS transistor includes a gate structure that is disposed between a source region and a drain region defined in the semiconductor substrate. The gate structure generally comprises a gate electrode formed on a gate dielectric material. The gate electrode controls a flow of charge carriers, beneath the gate dielectric, in a channel region that is formed between the drain region and the source region, so as to turn the transistor on or off. The channel, drain and source regions are collectively referred to in the art as a "transistor junction". There is a constant trend to reduce the dimensions of the transistor junction and, as such, decrease the gate electrode width in order to facilitate an increase in the operational speed of such transistors.

The gate electrode is generally formed of doped polysilicon (Si), while the gate dielectric material may comprise a thin layer (e.g., 20 to 60 Angstroms) of a high dielectric constant material (e.g., a dielectric constant greater than 4.0) such as, hafnium dioxide (HfO₂), hafnium silicon dioxide (HfSiO₂), hafnium silicon oxynitride (HfSiON), and the like. Such dielectric materials having a dielectric constant greater than 4.0 are referred to in the art as "high-K" materials. The gate dielectric material may also comprise a layer of silicon nitride (Si₃N₄), silicon dioxide (SiO₂), and the like.

The CMOS transistor may be fabncated by defining source and drain regions in the semiconductor substrate (e.g., doping regions in the substrate using an ion implantation process). Thereafter, the material layers that comprise the gate (e.g., high-K dielectric layer and polysilicon layer) are deposited on the substrate and patterned using sequential plasma etch processes to the form the gate structure.

The plasma-etch process used for patterning the polysilicon layer generally includes gas chemistries that produce polymeric residues, which may accumulate on sidewalls of the gate structure. Thereafter, during subsequent plasma etching of the high-K dielectric layer, such residues may interfere with processing of the substrate, e.g., the residues may increase the topographic dimensions of the gate structure. Additionally, the polymeric residues may contaminate the substrate or cause difficulties in depositing subsequent layers.

Typically, the polymeric residues are removed using a wet etch process. However, such processes are time consuming and increase the cost of fabricating the gate structure.

Therefore, there is a need in the art for an improved method for fabricating a gate structure of a field effect transistor.

### SUMMARY OF THE INVENTION

This and related problems are solved by the method according to claim 1 and 8, and the computer-readable medium according to claim 19.
Preferred embodiments, improvements and further aspects of the invention are disclosed in the description, the figures and the dependent claims.

The present invention is a method for fabricating a gate structure of a field effect transistor. The gate structure is preferably formed by sequentially etching a material stack comprising a gate electrode layer formed on a gate dielectric layer. Prior to etching the gate dielectric layer, polymeric residues formed on the substrate when the gate electrode is etched are preferably removed. The polymeric residue is removed by exposing the substrate to a plasma comprising one or more fluorocarbon containing gases and, possibly, at least one inert gas.

### BRIEF DESCRIPTION OF THE DRAWINGS

The teachings of the present invention can be readily understood by considering the following detailed description in conjunction with the accompanying drawings, in which:

FlG. 1 depicts a flow diagram of a method for fabricating a gate structure of a field effect transistor in accordance with one embodiment of the present invention;

FIGS. 2A-2F depict a series of schematic, cross-sectional views of a substrate having the gate structure being formed in accordance with the method of FIG. 1;

FIG. 3 depicts a schematic diagram of an exemplary plasma processing apparatus of the kind used in performing portions of the inventive method; and

FIG. 4 is a table summarizing the processing parameters of one exemplary embodiment of the inventive method when practiced using the apparatus of FIG. 3.

To facilitate understanding, identical reference numerals have been used, where possible, to designate identical elements that are common to the figures.

It is to be noted, however, that the appended drawings illustrate only exemplary embodiments of this invention and are therefore not to be considered limiting of its scope, for the invention may admit to other equally effective embodiments.

### DETAILED DESCRIPTION

The present invention is a method for fabricating a gate structure of a field effect transistor, such as a complementary metal-oxide-semiconductor (CMOS) field effect transistor. The gate structure is formed by sequentially etching a material stack comprising a gate electrode layer formed on a gate dielectric layer. Prior to etching the gate dielectric layer, polymeric residues formed on the substrate when the gate electrode is etched are removed. The polymeric residue is removed by exposing the substrate to a plasma comprising one or more fluorocarbon containing gases and at least one inert gas.

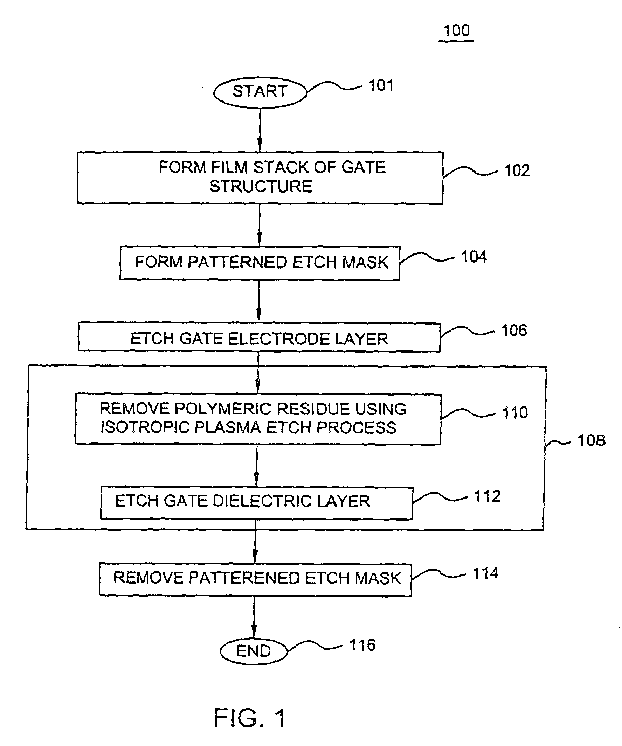

FIG. 1 depicts a flow diagram of one embodiment of the inventive method for fabricating a gate structure of a CMOS transistor as sequence 100. The sequence 100 includes the processes that are performed upon a film stack of the gate structure during fabrication of the CMOS transistor.

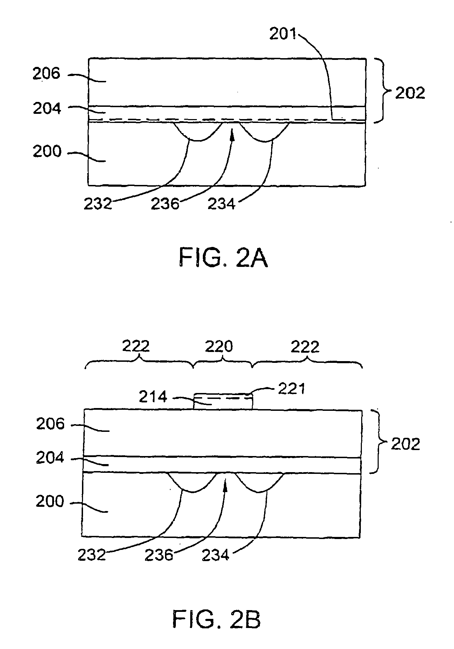

FIGS. 2A-2F depict a series of schematic, cross-sectional views of a substrate having a film stack of the gate structure being fabricated using sequence 100. The cross-sectional views in FIGS. 2A-2F relate to individual processing steps used to fabricated the gate structure. To best understand the invention, the reader should simultaneously refer to FIG. 1 and FIGS. 2A-2F. Sub-processes and lithographic routines (e.g., exposure and development of photoresist, wafer cleaning procedures, and the like) are well known in the art and, as such, are not shown in FIG. 1 and FIGS. 2A-2F. The images in FIGS. 2A-2F are not depicted to scale and are simplified for illustrative purposes.

The sequence 100 starts at step 101 and proceeds to step 102, when a gate electrode stack 202 is formed on a substrate 200 (FIG. 2A). The substrate 200 (e.g, a silicon (Si) wafer, and the like) comprises doped source regions (wells) 232 and drain regions (wells) 234 that are separated by a channel region 236. In an alternate embodiment, the substrate 200 may further comprise a barrier film 201 (shown in broken line in FIG. 2A only) used to protect the channel region 236 from contaminants (e.g., oxygen (O₂)) that may diffuse therein from the gate electrode stack 202. The barrier film 201 may comprise a dielectric material such as silicon dioxide (SiO₂), silicon nitride (Si₃N₄), and the like.

The gate electrode stack 202 generally comprises a gate electrode layer 206 and a gate dielectric layer 204. In one exemplary embodiment, the gate electrode layer 206 is formed of doped polysilicon (Si) to a thickness of about 500 to 6000 Angstroms and the gate dielectric layer 204 is formed of hafnium dioxide (HfO₂) to a thickness of about 10 to 60 Angstroms. Alternatively, the gate dielectric layer 204 may comprise one or more high-K dielectric materials having a dielectric constant greater than 4.0, such as hafnium silicon dioxide (HfSiO₂), hafnium silicon oxynitride (HfSiON), and the like. It should be understood, however, that the gate electrode stack 202 may comprise layers formed of other materials or layers having different thickness.

The layers that comprise the gate electrode stack 202 may be formed using any conventional deposition technique, such as atomic layer deposition (ALD), physical vapor deposition (PVD), chemical vapor deposition (CVD), plasma enhanced CVD (PECVD), and the like. Fabrication of the CMOS field effect transistors may be performed using the respective processing modules of CENTURA®, ENDURA®, and other semiconductor wafer processing systems available from Applied Materials, Inc. of Santa Clara, California.

At step 104, a patterned mask 214 is formed on the gate electrode layer 206 in region 220 (FIG. 2B). The patterned mask 214 defines the location and topographic dimensions of the gate structure to be formed. In the depicted embodiment, the patterned mask 214 protects the channel region 236 and portions of the source region 232 and the drain region 234, while exposing adjacent regions 222 of the gate electrode stack 202.

The patterned mask 214 is generally a hard mask formed of a material that is resistant to etchants used during fabrication of the gate structure, and which are stable at temperatures of up to 350 degrees Celsius. Temperatures of up to 350 degrees Celsius may be used for removal of the polymeric residues and for etching the gate dielectric layer 204 (discussed below with reference to step 108). The patterned mask 214 may comprise dielectric materials such as, silicon dioxide (SiO₂), α-carbon (amorphous carbon), Advanced Patterning Film™ (APF) (available from Applied Materials, Inc. of Santa Clara, California), and the like. In one illustrative embodiment, the patterned mask 214 is formed of silicon dioxide (SiO₂).

The patterned mask 214 may further comprise an optional anti-reflective layer 221 (shown with broken lines in FIG. 2B) that controls the reflection of light used to pattern the mask. As feature sizes are reduced, inaccuracies in the etch mask pattern transfer process can arise from optical limitations that are inherent to the lithographic process, such as light reflection. The anti-reflective layer 221 may comprise, for example, silicon nitride (Si₃N₄), polyamides, and the like.

Processes of applying the patterned mask 214 are described, for example, in commonly assigned U.S. patent applications serial number 10/245,130, filed September 16, 2002 (Attorney docket number 7524) and serial number 10/338,251, filed January 6, 2003 (Attorney docket number 7867), which are incorporated herein by reference.

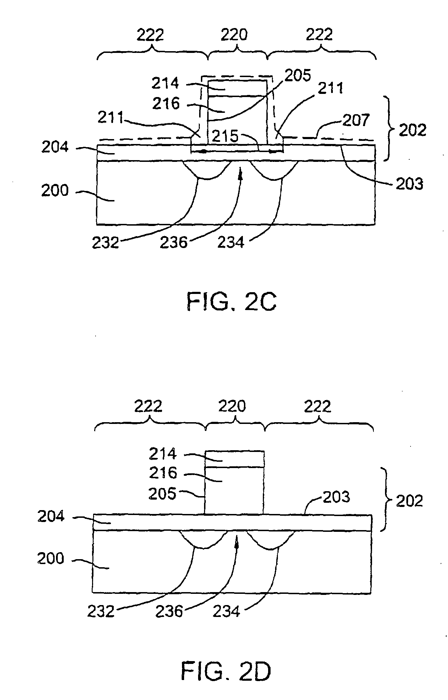

At step 106, the gate electrode layer 206 is etched and removed in regions 222 forming a gate electrode 216 (e.g., polysilicon gate electrode) (FIG. 2C). The gate electrode layer 206 may be plasma etched using a halogen-containing gas mixture comprising one or more halogen-containing gases such as chlorine (Cl₂), hydrogen bromide (HBr), carbon tetrafluoride (CF₄), and the like. The halogen-containing gas mixture may optionally include an inert diluent gas, such as at least one of nitrogen (N₂), argon (Ar), helium (He), neon (Ne), and the like. In one embodiment, step 106 uses the patterned mask 214 as an etch mask and the gate dielectric layer 204 (e.g., hafnium dioxide layer) as an etch stop layer.

Step 106 can be performed in an etch reactor such as a Decoupled Plasma Source (DPS) II reactor of the CENTURA® system, commercially available from Applied Materials, Inc. of Santa Clara, California. The DPS II reactor uses a power source (i.e., an inductively coupled antenna) to produce a high-density inductively coupled plasma. To determine the endpoint of the etch process, the DPS II reactor may also include an endpoint detection system that monitors plasma emissions at a particular wavelength, controls the process time, or performs laser interferometery, and the like.

In one illustrative embodiment, the gate electrode layer 206 comprising polysilicon is etched in the DPS II reactor by providing hydrogen bromide (HBr) at a flow rate of 20 to 300 sccm, chlorine (Cl₂) at a flow rate of 20 to 300 sccm (i.e., a HBr:Cl₂ flow ratio ranging from 1:15 to 15:1), nitrogen (N₂) at a flow rate of 0 to 200 sccm, applying power to an inductively coupled antenna between 200 and 3000 W, applying a cathode bias power between 0 and 300 W and maintaining a wafer temperature between 20 and 80 degrees Celsius at a pressure in the process chamber between 2 and 100 mTorr. One exemplary process provides hydrogen bromide (HBr) at a flow rate of 40 sccm, chlorine (Cl₂) at a flow rate of 40 sccm (i.e., a HBr:Cl₂ flow ratio of about 1:1), nitrogen (N₂) at a flow rate of 20 sccm, applies 1100 W of power to the inductively coupled antenna, 20 W of cathode bias power and maintains a wafer temperature of 45 degrees Celsius at a chamber pressure of 45 mTorr. Such a process provides etch selectivity for polysilicon (layer 206) over hafnium dioxide (layer 204) of at least 100:1, as well as etch selectivity for polysilicon over silicon dioxide (SiO₂) (mask 214) of about 10:1.

During step 106, a portion of the material removed from the gate electrode layer 206 combines with components of the etchant gas mixture (e.g., halogen-containing gases) as well as components of the mask 214 forming non-volatile compounds. Such non-volatile compounds may become re-deposited onto the substrate 200, forming a polymeric residue layer 207 (shown with broken lines in FIG. 2C). The polymeric residue layer 207 is typically found on the mask 214, the sidewalls 205 of the gate electrode 216, the surface 203 of the gate dielectric layer 204, and elsewhere on the substrate 200. The residue layer 207 may typically have a thickness of about 10 to 50 Angstroms across the topographic surfaces of the substrate 200.

The polymeric residue layer 207 is generally resistant to the etch chemistries used for patterning the gate dielectric layer 204 (discussed in reference to step 108 below). As such, unless the residue layer 207 is removed from the substrate 200, the dimensional accuracy of the gate structure may be compromised when the gate dielectric layer 204 is subsequently patterned. In one exemplary embodiment, corner regions 211 of the residue layer 207 may act as a mask, having a width 215 that is wider than the desired width of the gate structure being formed.

At step 108, the polymeric residue layer 207 is removed and the gate dielectric layer 204 is etched in regions 222 (FIGS. 2D-2E). In general terms, step 108 uses sequential plasma etch processes comprising a first time period 110 during which the polymeric residue layer 207 is removed followed by a second time period 112 in which the gate dielectric layer 204 is etched.

The first and second time periods 110, 112 may be sequentially performed using either dedicated etch reactors or a single process chamber (i.e., in-situ), for example, in a Decoupled Plasma Source-High Temperature (DPS-HT) module of the CENTURA® system. The DPS-HT module and the DPS II module each have generally similar configurations, however, substrate temperature in the DPS-HT module may be controlled within a range from about 200 to 350 degrees Celsius.

In one embodiment, steps 106 and 108 are performed using etch reactors which are components of a single CENTURA® system. Step 106 may be performed, for example, in a DPS II module of the CENTURA® system, then the substrate 200 may be transferred through a vacuumed plenum of the system, using a resident wafer robot, to the DPS-HT module of the same system, in which step 108 may be performed. Such an embodiment protects the gate structure being fabricated from contamination caused by exposure to a non-vacuumed portion of the manufacturing environment and increases productivity for fabrication of the gate structure.

During the first time period 110, the polymeric residue layer 207 is removed from the sidewalls 205 of the gate electrode 216, the surface 203 of the gate dielectric layer 204, as well as elsewhere on the film stack 202 and the substrate 200 (FIG. 2D). In one exemplary embodiment, the first time period 110 uses an isotropic plasma etch process including a gas mixture comprising one or more fluorocarbon-containing gases (e. g., carbon tetrafluoride (CF₄), trifluoromethane (CHF₃), fluoroethane (C₂F₆), and the like) and at least one inert gas (e. g., nitrogen (N₂), argon (Ar), neon (Ne), and the like). Isotropic plasma processes generally use a high-density plasma source (e.g., inductively coupled plasma source), elevated substrate temperatures (e.g., at least about 200 degrees Celsius), and little (e.g., not greater than about 30 W) or no (i.e., 0 W) substrate bias.

In one illustrative embodiment, the polymeric residue layer 207 is removed using the DPS-HT module by providing carbon tetrafluoride (CF₄) at a flow rate of 20 to 200 sccm, nitrogen (N₂) at a flow rate of 5 to 100 sccm (i.e., a CF₄:N₂ flow ratio ranging from 1:5 to 40:1), applying power to an inductively coupled antenna between 200 and 2000 W, applying a cathode bias power of not greater than about 30 W, and maintaining a wafer temperature between 200 and 350 degrees Celsius at a pressure in the process chamber between 2 and 50 mTorr. One exemplary process provides CF₄ at a flow rate of 100 sccm, N₂ at a flow rate of 20 sccm (i.e., a CF₄:N₂ flow ratio of about 5:1), applies 1000 W of power to the antenna, 0 W of bias power, maintains a wafer temperature of 350 degrees Celsius, and a pressure of 4 mTorr. Such a process provides etch selectivity for the residue (layer 207) over hafnium dioxide (layer 204) of at least 50:1, as well as etch selectivity for the residue (layer 207) over polysilicon (layer 216) and silicon dioxide (SiO₂) (mask 214) of about 1:1 and about 1:1, respectively. The duration of the first time period 110 is generally about 10 to 15 seconds.

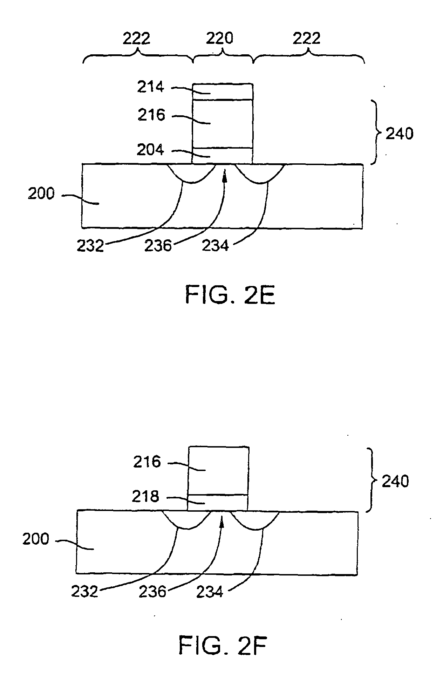

During the second time period 112, the gate dielectric layer 204 is etched and removed in regions 222, thereby forming a gate structure 240 in region 220 (FIG. 2E). In one exemplary embodiment, the second time period 112 uses a gas mixture comprising a halogen-containing gas (e.g., chlorine (Cl₂), hydrogen chloride (HCl), boron trichloride (BCl₃), and the like) along with a reducing gas (e.g., carbon monoxide (CO), oxygen (O₂), and the like) for etching the hafnium dioxide (HfO₂) high-K gate dielectric layer 204. The second time period 112 uses the patterned mask 214 as an etch mask and the material comprising the substrate 200 (e.g., silicon) as an etch stop layer.

In one illustrative embodiment, the gate dielectric layer 204 comprising hafnium dioxide is etched in the DPS-HT module using a gas mixture including chlorine (Cl₂) at a flow rate of 2 to 300 sccm, carbon monoxide (CO) at a flow rate of 2 to 200 sccm (e.g., a Cl₂:CO flow ratio ranging from 1:5 to 5:1), applying power to an inductively coupled antenna of between 200 and 3000 W, applying a cathode bias power between 0 and 300 W, and maintaining a wafer temperature between 200 and 350 degrees Celsius at a pressure in the process chamber of between 2 and 100 mTorr. One illustrative process provides chlorine (Cl₂) at a flow rate of 40 sccm, carbon monoxide (CO) at a flow rate of 40 sccm (i.e., a Cl₂:CO flow ratio of about 1:1), applies 1100 W of power to the inductively coupled antenna, 20 W of bias power to the cathode and maintains a wafer temperature of 350 degrees Celsius at a chamber pressure of 4 mTorr. Such a process provides etch selectivity for the hafnium dioxide (HfO₂) (layer 204) over polysilicon and/or silicon (layer 216, substrate 200) of at least 3:1, as well as etch selectivity for hafnium dioxide (HfO₂) (layer 204) over silicon dioxide (SiO₂) (mask 214) of about 30:1.

At step 114, the patterned mask 214 is, optionally, removed from the gate structure 240 (FIG. 2F). Processes for removing the patterned mask 214 are described, for example, in commonly assigned U.S. patent applications serial number 10/245,130, filed September 16, 2002 (Attorney docket number 7524) and serial number 10/338,251, filed January 6, 2003 (Attomey docket number 7867), which are incorporated herein by reference.

At step 116, the sequence 100 ends.

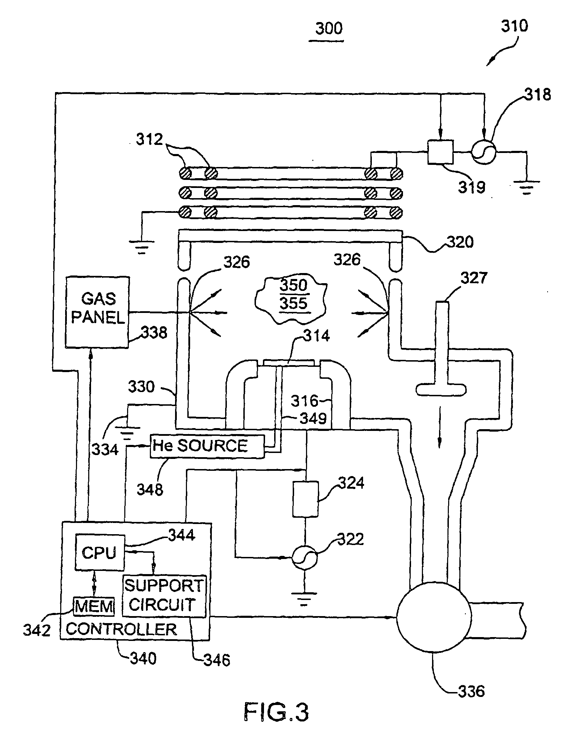

FIG. 3 depicts a schematic diagram of the exemplary Decoupled Plasma Source (DPS) II or DPS-HT etch reactor 300 that may be used to practice portions of the invention. The DPS II and DPS-HT reactors are generally used as process modules of the CENTURA® system available from Applied Materials, Inc. of Santa Clara, California.

The reactor 300 comprises a process chamber 310 having a wafer support pedestal 316 within a conductive body (wall) 330, and a controller 340.

The chamber 310 is supplied with a substantially flat dielectric ceiling 320 (e.g., DPS II, DPS-HT modules). Other modifications of the chamber 310 may have other types of ceilings, e.g., a dome-shaped ceiling (e.g., DPS Plus module). Above the ceiling 320 is disposed an antenna comprising at least one inductive coil element 312 (two co-axial elements 312 are shown). The inductive coil element 312 is coupled, through a first matching network 319, to a plasma power source 318. The plasma power source 318 typically is capable of producing up to 3000 W at a tunable frequency in a range from 50 kHz to 13.56 MHz.

The support pedestal (cathode) 316 is coupled, through a second matching network 324, to a biasing power source 322. The biasing power source 322 generally is capable of producing up to 500 W at a frequency of approximately 13.56 MHz. The biasing power may be either continuous or pulsed power. In other embodiments, the biasing power source 322 may be a DC or pulsed DC source.

The controller 340 comprises a central processing unit (CPU) 344, a memory 342, and support circuits 346 for the CPU 344 and facilitates control of the components of the chamber 310 and, as such, of the etch process, as discussed below in further detail.

In operation, a semiconductor wafer 314 is placed on the pedestal 316 and process gases are supplied from a gas panel 338 through entry ports 326 to form a gaseous mixture 350. The gaseous mixture 350 is ignited into a plasma 355 in the chamber 310 by applying power from the plasma source 318 and biasing power source 322 to the inductive coil element 312 and the cathode 316, respectively. The pressure within the interior of the chamber 310 is controlled using a throttle valve 327 and a vacuum pump 336. Typically, the chamber wall 330 is coupled to an electrical ground 334. The temperature of the wall 330 is controlled using liquid-containing conduits (not shown) that run through the wall 330.

The temperature of the wafer 314 is controlled by stabilizing a temperature of the support pedestal 316. In one embodiment, the helium gas from a gas source 348 is provided via a gas conduit 349 to channels (not shown) formed in the pedestal surface under the wafer 314. The helium gas is used to facilitate heat transfer between the pedestal 316 and the wafer 314. During processing, the pedestal 316 may be heated by a resistive heater (not shown) within the pedestal to a steady state temperature and then the helium gas facilitates uniform heating of the wafer 314. Using such thermal control, the wafer 314 is maintained at a temperature of between about 20 and 80 degrees Celsius for the DPS II module or between about 200 and 350 degrees Celsius for the DPS-HT module.

Those skilled in the art will understand that other etch chambers may be used to practice the invention, including chambers with remote plasma sources, electron cyclotron resonance (ECR) plasma chambers, and the like.

To facilitate control of the process chamber 310 as described above, the controller 340 may be one of any form of general-purpose computer processor that can be used in an industrial setting for controlling various chambers and sub-processors. The memory 342, or computer-readable medium, of the CPU 344 may be one or more of readily available memory such as random access memory (RAM), read only memory (ROM), floppy disk, hard disk, or any other form of digital storage, local or remote. The support circuits 346 are coupled to the CPU 344 for supporting the processor in a conventional manner. These circuits include cache, power supplies, clock circuits, input/output circuitry and subsystems, and the like. The inventive method is generally stored in the memory 342 as a software routine. The software routine may also be stored and/or executed by a second CPU (not shown) that is remotely located from the hardware being controlled by the CPU 344.

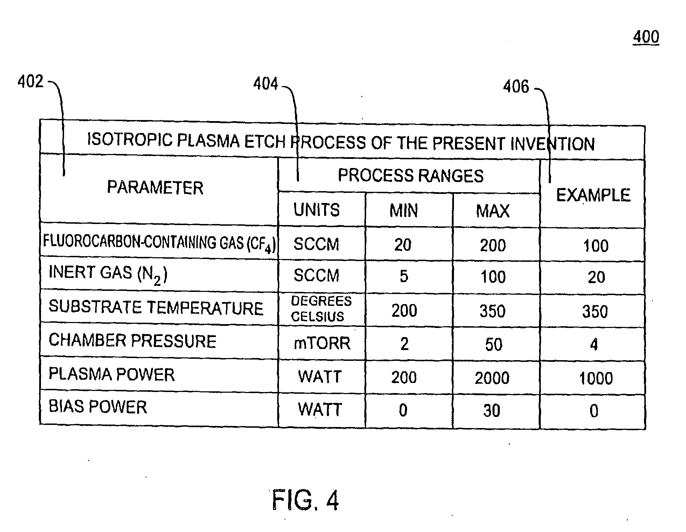

FIG. 4 is a table 400 summarizing the process parameters of the isotropic plasma etch process described herein using the DPS HT reactor. The process parameters summarized in column 402 are for one exemplary embodiment of the invention presented above. The process ranges are presented in column 404. Exemplary process parameters for removing polymeric residue layer 207 are presented in column 406. It should be understood, however, that the use of a different plasma etch reactor may necessitate different process parameter values and ranges.

The invention may be practiced using other semiconductor wafer processing systems wherein the processing parameters may be adjusted to achieve acceptable characteristics by those skilled in the art by utilizing the teachings disclosed herein without departing from the spirit of the invention.

Although the forgoing discussion referred to fabrication of the field effect transistor, fabrication of the other devices and structures used in integrated circuits can benefit from the invention.

While the foregoing is directed to the illustrative embodiment of the present invention, other and further embodiments of the invention may be devised without departing from the basic scope thereof, and the scope thereof is determined by the claims that follow.

## Claims

1. A method for removing post-etch residue, comprising:
(a) providing a substrate having a polysilicon layer formed on a hafnium-containing layer;
(b) forming a patterned mask on the polysilicon layer;
(c) plasma etching the polysilicon layer, wherein a polymeric residue is deposited on the substrate; and
(d) removing the polymeric residue using a plasma comprising one or more fluorocarbon-containing gases.

2. The method of claim 1 wherein the hafnium-containing layer comprises a material selected from the group consisting of hafnium dioxide (HfO₂), hafnium silicon dioxide (HfSiO₂), hafnium silicon oxynitride (HfSiON).

3. The method of claim 1 or 2 wherein the fluorocarbon-containing gas of step (d) comprises one or more gases selected from the group consisting of carbon tetrafluoride (CF₄), trifluoromethane (CHF₃) and fluoroethane (C₂F₆).

4. The method according to any one of the claims 1 to 3 wherein the fluorocarbon-containing gas of step (d) has a selectivity for the polymeric residue over the hafnium-containing layer of at least about 50:1

5. The method according to any one of the claims 1 to 4 wherein the fluorocarbon-containing gas of step (d) has a selectivity for the polymeric residue over the polysilicon layer of at least 1:1.

6. The method according to any one of the claims 1 to 5 wherein step (d) is performed at a substrate temperature between 200 and 350 degrees Celsius.

7. The method according to any one of the claims 1 to 6 wherein the step (d) comprises:
providing carbon tetrafluoride (CF₄) and nitrogen (N₂) at a flow ratio CF₄:N₂ in a range from 1: 5 to 40:1;
maintaining the substrate at a temperature between about 200 and 350 degrees Celsius;
applying power to an inductively coupled antenna between about 200 and 2000 W;
applying a cathode bias power of not greater than about 30 W; and
maintaining a chamber pressure between about 2 and 50 mTorr.

8. A method for forming a gate structure of a field effect transistor, comprising:
(a) providing a substrate having a gate electrode layer formed on a gate dielectric layer over a plurality of transistor junctions defined on the substrate;
(b) forming a patterned mask defining a gate structure on the gate electrode layer;
(c) plasma etching the gate electrode layer to define the gate structure therein, wherein a polymeric residue is deposited on the substrate;
(d) removing the polymeric residue using a plasma comprising one or more fluorocarbon-containing gases; and
(e) plasma etching the gate dielectric layer to define the gate structure therein.

9. The method of claim 8 wherein the gate dielectric layer comprises a material selected from the group consisting of hafnium dioxide (HfO₂), hafnium silicon dioxide (HfSiO₂), hafnium silicon oxynitride (HfSiON).

10. The method according to any one of the claims 8 to 9 wherein the gate electrode layer comprises polysilicon.

11. The method according to any one of the claims 8 to 10 wherein the steps (d) and (e) are performed sequentially in one processing chamber.

12. The method according to any one of the claims 8 to 11 wherein the fluorocarbon-containing gas of step (d) comprises one or more gases selected from the group consisting of carbon tetrafluoride (CF₄), trifluoromethane (CHF₃) and fluoroethane (C₂F₆).

13. The method according to any one of the claims 8 to 12 wherein the fluorocarbon-containing gas of step (d) has a selectivity for the polymeric residue over the gate dielectric layer of at least about 50:1.

14. The method according to any one of the claims 8 to 13 wherein the fluorocarbon-containing gas of step (d) has a selectivity for the polymeric residue over the gate electrode layer of at least 1:1.

15. The method according to any one of the claims 8 to 14 wherein the at least one inert gas of step (d) is selected from the group consisting of nitrogen (N₂), argon (Ar) and neon (Ne).

16. The method according to any one of the claims 8 to 15 wherein step (d) is performed at a substrate temperature between 200 and 350 degrees Celsius.

17. The method according to any one of the claims 8 to 16 wherein the step (d) comprises: providing carbon tetrafluoride (CF₄) and nitrogen (N₂) at a flow ratio CF₄:N₂ in a range from 1:5 to 40:1.

18. The method according to any one of the claims 8 to 16 wherein the step (d) comprises: providing carbon tetrafluoride (CF₄) and nitrogen (N₂) at a flow ratio CF₄:N₂ in a range from 1:5 to 40:1;
maintaining the substrate at a temperature between about 200 and 350 degrees Celsius;
applying power to an inductively coupled antenna between about 200 and 2000 W;
applying a cathode bias power of not greater than about 30 W; and
maintaining a chamber pressure between about 2 and 50 mTorr.

19. A computer-readable medium containing software that when executed by a computer causes a semiconductor wafer processing system to fabricate a gate structure of a field effect transistor using a method, comprising:
(a) providing a substrate having a gate electrode layer formed on a gate dielectric layer over a plurality of transistor junctions defined in the substrate;
(b) forming a patterned mask defining a gate structure on the gate electrode layer;
(c) plasma etching the gate electrode layer to define the gate structure therein, wherein a polymeric residue is deposited on the substrate;
(d) removing the polymeric residue using a plasma comprising one or more fluorocarbon-containing gases; and
(e) plasma etching the gate dielectric layer to define the gate structure therein.

20. The computer-readable medium of claim 19 wherein the gate dielectric layer comprises a material selected from the group consisting of hafnium dioxide (HfO₂), hafnium silicon dioxide (HfSiO₂), hafnium silicon oxynitride (HfSiON).

21. The computer-readable medium of claim 19 or 20 wherein the steps (d) and (e) are performed sequentially in one processing chamber.

22. The computer-readable medium according to any one of the claims 19 to 21 wherein the fluorocarbon-containing gas of step (d) comprises one or more gases selected from the group consisting of carbon tetrafluoride (CF₄), trifluoromethane (CHF₃) and fluoroethane (C₂F₆).

23. The computer-readable medium according to any one of the claims 19 to 22 wherein the fluorocarbon-containing gas of step (d) has a selectivity for the polymeric residue over the gate dielectric layer of at least about 50:1.

24. The computer-readable medium according to any one of the claims 19 to 23 wherein the fluorocarbon-containing gas of step (d) has a selectivity for the polymeric residue over the gate electrode layer of at least 1:1.

25. The computer-readable medium according to any one of the claims 19 to 24 wherein step (d) is performed at a substrate temperature between 200 and 350 degrees Celsius.
